# EUROPEAN PATENT APPLICATION

(11) **EP 1 398 401 A2**
(43) Date of publication of application: **17.03.2004**
(21) Application number: 03019693.5
(22) Date of filing: 09.09.2003
(51) Int. Cl.: C30B 29/04

(54) **Method for creating diamond**

(30) Priority: 10.09.2002 JP 2002263669
(71) Applicant: HOKKAIDO UNIVERSITY, Sapporo City Hokkaido (JP)
(72) Inventor: Kouchi, Akira, Sapporo City Hokkaido (JP)
(74) Representative: Wibbelmann, Jobst, Dr., Dipl.-Chem.

(57) **Abstract**

An organic chemical made of acetamide, urea and the like is mixed with water to form a mixture thereof, which is heated to form a given reacted sample. In order to remove water and volatile organic matters, the reacted sample is frozen and dried, and then, heated under vacuum condition to create diamond.

## Description

### BACKGROUND OF THE INVENTION

### Field of the Invention

This invention relates to a method for creating diamond.

### Description of the prior art

Conventionally, diamond used to be artificially shaped filmy by means of physical vapor deposition (PVD) method or chemical vapor deposition (CVD) method. In the PVD method, a hydrocarbon raw material gas is supplied onto a substrate heated at 700°C or over, to create a diamond thin film. In the CVD method, a hydrocarbon raw material gas is supplied onto a substrate heated at a temperature within a range of 700-900°C, to be thermally decomposed and thus, to create a diamond thin film.

With the above-mentioned methods, however, it is required that the substrate is heated at a higher temperature to excite the hydrocarbon raw material gas to a higher energy state.

In this point of view, such an attempt is made as to employ a given organic solvent to create diamond at lower temperature (Japanese patent Application Laid-open 1-199298). In the conventional technique, diamond can be created only by heating the substrate to a temperature of several ten deg C, but a large amount of current must be flowed in the organic solvent. As a result, the organic solvent as a raw material must be excited to a higher energy state.

In addition, although various methods for creating diamond on a given substrate are proposed, as a result, all of the methods require to excite a raw material to a higher energy state through the application of microwave or electric discharge by the application of higher voltage.

### SUMMERY OF THE INVENTION

It is an object of the present invention to provide a new method for creating diamond by using a raw material of lower energy state.

In order to achieve the above object, this invention relates to a method for creating diamond, comprising the steps of:
preparing an organic chemical made of acetamide, urea, ethylene glycol, glycolic acid, lactamide, glycerol, hexamethylenetetramine, indene, 1,2-dimethylnaphtalene, 1,4- diisopropenylbenzene, cyclohexylphenylketone, 4'-cyclohexylacetophenone, 4-(1-adamantyl)phenol, 4,4'- methylenebis(2,6-dimethylphenol), α,α'-bis(4-hydroxyphenyl)-1,4- diisopropylbenzene, phenanthrene, lauric acid, sebacic acid and eicosanoic acid,
forming a mixture made of the organic chemical and water,
heating the mixture to form a given reacted sample,
freezing and drying the reacted sample to remove water and volatile organic matters therefrom,
   and
heating the reacted sample under vacuum condition to create diamond.

The inventors had intensely studied to achieve the above object, and then, found out the following fact of matter. If the organic chemical made of the above-mentioned organic matters is mixed with water to form a mixture, and then, heated, frozen under vacuum condition and heated under vacuum condition successively, the intended diamond can be synthesized and created not through the high energy state of the mixture as a raw material.

In the present invention, it is only required to heat the substrate for the diamond to be synthesized at a temperature within a range of about 150-400°C in the first heating step and the second heating step under the vacuum condition without any other exciting means. In other words, in the present invention, the intended diamond can be synthesized and created at the lower temperature within a range of about 150-400°C through the lower energy state of the mixture as a raw material.

### BRIEF DESCRIPTION OF THE DRAWINGS

For better understanding of the present invention, reference is made to the attached drawings, wherein
Fig. 1 is a structural view showing a heating apparatus to be employed in the present invention,
Fig. 2 is a structural view showing a vacuum freezing apparatus to be employed in the present invention,
Fig. 3 is a structural view showing a vacuum heating apparatus to be employed in the present invention, and
Fig. 4 is a TEM photograph of a diamond created according to the present invention.

### DESCRIPTION OF THE PREFERRED EMBODIMENTS

This invention will be described in detail with reference to the accompanying drawings. First of all, the organic chemical is mixed with water to form the mixture thereof. The organic chemical is made of acetamide (CH₃CONH₂), urea (H₂NCONH₂), ethylene glycol (HOCH₂CH₂OH), glycolic acid (HOCH₂COOH), lactamide (CH₃CH(OH)CONH₂), glycerol (HOCH₂CH(OH)CH₂OH), hexamethylenetetramine (C₆H₁₂N₄), indene (C₉H₈), 1,2-dimethylnaphtalene (C₁₀H₆(CH₃)₂), 1,4- diisopropenylbenzene (C₆H₄[C(CH₃)CH₂]₂), cyclohexylphenylketone (C₆H₁₁COC₆H₅), 4'-cyclohexylacetophenone (C₆H₁₁C₆H₄COCH₃), 4-(1-adamantyl)phenol (C₁₀H₁₅C₆H₄OH), 4,4'-methylenebis(2,6-dimethylphenol) (C₁₇H₂₀O₂), α,α'-bis(4-hydroxyphenyl)-1,4-diisopropylbenzene (HOC₆H₄C(CH₃)₂C₆H₄C(CH₃)₂C₆H₄OH), phenanthrene (C₁₄H₁₀), lauric acid (CH₃(CH₂)₁₀COOH), sebacic acid (HOOC(CH₂)₈COOH) and eicosanoic acid (CH₃(CH₂)₁₈COOH).

The organic chemical is blended of acetamide, urea and the like, charged into a vessel, agitated and mixed with the water

The mixed ratio of the organic chemical and the water is preferably set to 1:1 through 1:2, particularly to 1:1.5. In this case, the intended diamond can be synthesized and created effectively and efficiently at a lower energy state.

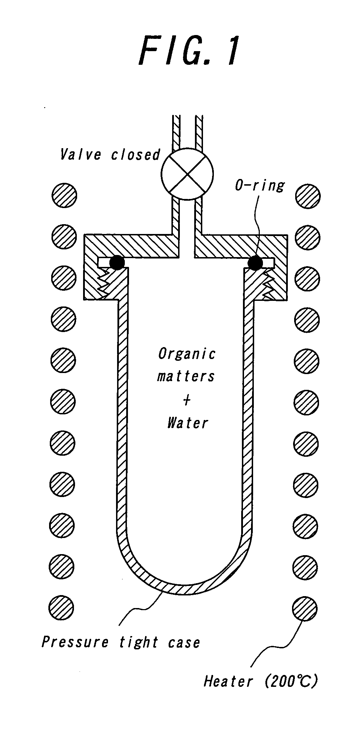

Then, the mixture is charged into the pressure tight case of the heating apparatus illustrated in Fig. 1, and then, heated to a predetermined temperature with the heater provided at the periphery of the pressure tight case. The heating temperature may be set to 200°C or below. In the present invention, since the mixture made of the organic chemical and the water is employed as the raw material, the intended diamond can be synthesized and created at the lower temperature of 200°C or below through the lower energy state of the mixture.

In the present invention, if the mixed ratio of the organic chemical and the water in the mixture is adjusted and the content of each organic matter composing the organic chemical is adjusted, the intended diamond can be synthesized and created even at 150°C. However, it may be difficult to synthesize and create the intended diamond lower than 150°C.

The heating period of time depends on the heating temperature, but may be preferably set within 24-168 hours.

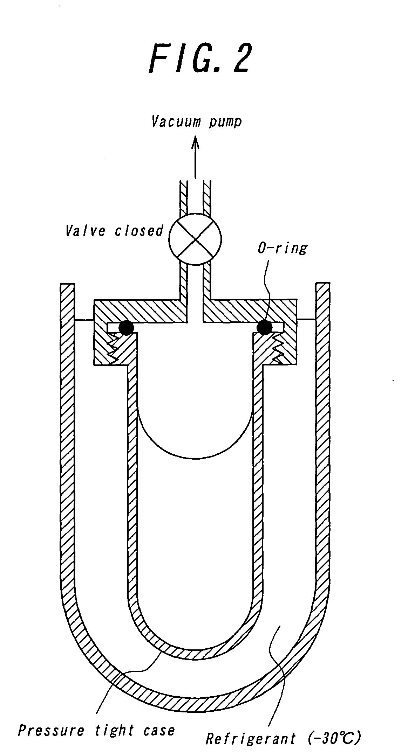

Then, the resultant thermally reacted sample is frozen and dried by using the vacuum freezing apparatus illustrated in Fig. 2., to remove water and volatile organic matters therefrom. Concretely, the reacted sample is charged into the pressure tight case of the vacuum freezing apparatus, and then, the interior of the pressure tight case is evacuated with the vacuum pump with flowing a refrigerant of about -30°C around the periphery of the pressure tight case. The freezing period of time depends on the capacity of the vacuum freezing apparatus, the amount of the reacted sample to be introduced into the vacuum freezing apparatus and the like.

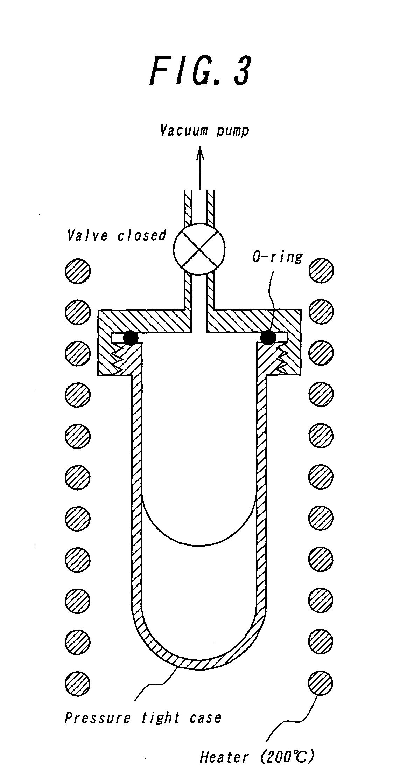

Then, the reacted sample is heated under vacuum condition by using the vacuum heating apparatus illustrated in Fig. 3 after the freezing and drying. Concretely, the reacted sample is charged into the pressure tight case of the vacuum heating apparatus, and the interior of the pressure tight case is evacuated with the vacuum pump with heating the reacted sample with the heater provided at the periphery of the pressure tight case.

In this case, the interior of the pressure tight case is preferably evacuated within a range of 10⁻¹-10⁻⁶Pa. In this case, the intended diamond can be synthesized and created in high purification.

since the mixture made of the organic chemical and the water is employed and the first heating treatment and the freezing treatment are performed prior to the second heating treatment under vacuum condition, the heating temperature in the second heating treatment can be set to 400°C or below. In other words, in the present invention, the intended diamond can be synthesized and created at the lower temperature of 400°C or below through the lower energy state of the reacted sample as a raw material.

In the present invention, if the mixed ratio of the organic chemical and the water in the mixture is adjusted and the content of each organic matter composing the organic chemical is adjusted, the intended diamond can be synthesized and created even at 200°C. However, it may be difficult to synthesize and create the intended diamond lower than 200°C.

The heating period of time depends on the heating temperature, but may be preferably set within 24-80 hours.

In this embodiment, although the heating apparatus illustrated in Fig. 1 is employed, another heating apparatus will do. Moreover, although the vacuum freezing apparatus illustrated in Fig. 2 is employed, another vacuum freezing apparatus will do. In addition, although the vacuum heating apparatus illustrated in Fig. 3 is employed, another vacuum heating apparatus will do.

### Example:

Such an attempt was made as to synthesize diamond on the above-mentioned process. In this Example, the organic chemical was blended as listed in Table 1. The first heating treatment was made for about 168 hours at 200°C by using the heating apparatus illustrated in Fig. 1. The second heating treatment was made for 80 hours at 200°C under a vacuum condition of 10⁻⁶Pa by using the vacuum heating apparatus illustrated in Fig. 3.

**Table 1**

| Organic matter | Chemical formula | Weight % |
|---|---|---|
| acetamide | CH₃CONH₂ | 6.7 |
| urea | H₂NCONH₂ | 0.8 |
| ethylene glycol | HOCH₂CH₂OH | 2.0 |
| glycol acid | HOCH₂COOH | 11.7 |
| lactamide | CH₃CH(OH)CONH₂ | 8.8 |
| glycerol | HOCH₂CH(OH)CH₂OH | 2.3 |
| hexamethylenetetramine | C₆H₁₂N₄ | 1.1 |
| indene | C₉H₈ | 7.6 |
| 1,2-dimethylnaphtalene | C₁₀H₆(CH₃)₂ | 2.6 |
| 1,4-diisopropenylbenzene | C₆H₄[C(CH₃)CH₂]₂ | 3.3 |
| cyclohexylphenylketone | C₆H₁₁COC₆H₅ | 8.1 |
| 4'-cyclohexylacetophenone | C₆H₁₁C₆H₄COCH₃ | 7.2 |
| 4-(1-adamantyl)phenol | C₁₀H₁₅C₆H₄OH | 2.1 |
| 4,4'-methylenebis(2,6- dimethylphenol) | C₁₇H₂₀O₂ | 2.3 |
| α,α'-bis(4-hydroxyphenyl)- 1,4-diisopropylbenzene | HOC₆H₄C(CH₃)₂C₆H₄C(CH₃)₂C₆H₄OH | 0.2 |
| phenanthrene | C₁₄H₁₀ | 11.0 |
| lauric acid | CH₃(CH₂)₁₀COOH | 6.2 |
| sebacic acid | HOOC(CH₂)₈COOH | 6.3 |
| eicosanoic acid | CH₃(CH₂)₁₈COOH | 9.7 |

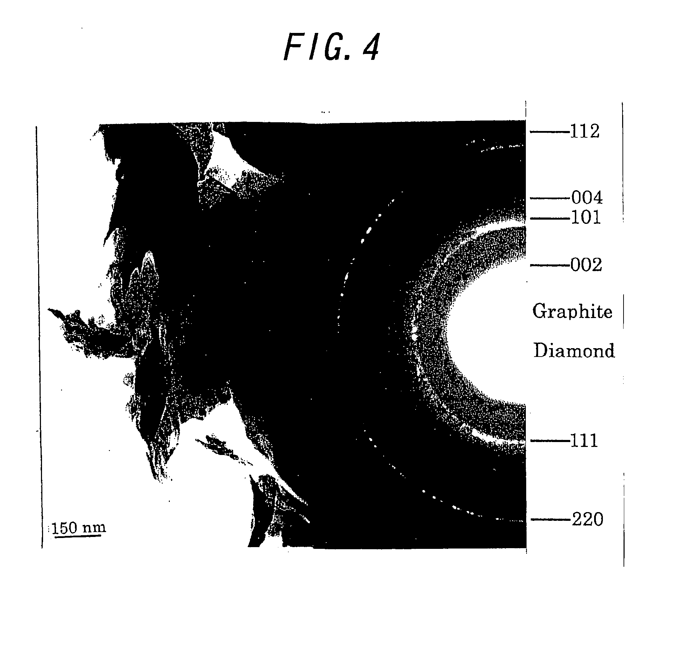

Fig. 4 is a TEM photograph of the resultant product. As is apparent from Fig. 4, in the product, graphite and diamond are created. Therefore, in this Example according to the present invention, it is turned out that diamond can be synthesized and created at the lower temperature of 200°C through the lower energy state of the raw material composed of the organic chemical listed in Table 1 and the water.

Although the present invention was described in detail with reference to the above examples, this invention is not limited to the above disclosure and every kind of variation and modification may be made without departing from the scope of the present invention.

As mentioned above, according to the present invention, a new method for creating diamond by using a raw material of lower energy state can be provided.

## Claims

1. A method for creating diamond, comprising the steps of:
preparing an organic chemical made of acetamide, urea, ethylene glycol, glycolic acid, lactamide, glycerol, hexamethylenetetramine, indene, 1,2-dimethylnaphtalene, 1,4- diisopropenylbenzene, cyclohexylphenylketone, 4'-cyclohexylacetophenone, 4-(1-adamantyl)phenol, 4,4'-methylenebis(2,6-dimethylphenol), α,α'-bis(4-hydroxyphenyl)-1,4- diisopropylbenzene, phenanthrene, lauric acid, sebacic acid and eicosanoic acid, forming a mixture made of said organic chemical and water, heating said mixture to form a given reacted sample, freezing and drying said reacted sample to remove water and volatile organic matters therefrom,
and
heating said reacted sample under vacuum condition to create diamond.

2. The creating method of diamond as defined in claim 1, wherein the mixed ratio of said organic chemical and said water in said mixture is set to 1:1 through 1:2.

3. The creating method of diamond as defined in claim 2, wherein the mixed ratio of said organic chemical and said water in said mixture is set to 1:1.5.

4. The creating method of diamond as defined in any one of claims 1-3, wherein said mixture is heated at a temperature of 200°C or below.

5. The creating method of diamond as defined in claim 4, wherein said mixture is heated within 150-200°C.

6. The creating method of diamond as defined in any one of claims 1-5, wherein said reacted sample is heated under a vacuum condition within a range of 10⁻¹-10⁻⁶Pa.

7. The creating method of diamond as defined in any one of claims 1-6, wherein said reacted sample is heated at a temperature of 400°C or below.

8. The creating method of diamond as defined in claim 7, wherein said reacted sample is heated within 200-400°C.

9. A mixture for creating diamond, comprising:
an organic chemical made of acetamide, urea, ethylene glycol, glycolic acid, lactamide, glycerol, hexamethylenetetramine, indene, 1,2-dimethylnaphtalene, 1,4- diisopropenylbenzene, cyclohexylphenylketone, 4'-cyclohexylacetophenone, 4-(1-adamantyl)phenol, 4,4'-methylenebis(2,6-dimethylphenol), α,α'-bis(4-hydroxyphenyl)-1,4-diisopropylbenzene, phenanthrene, lauric acid, sebacic acid and eicosanoic acid,
and
a water which is mixed with said organic chemical.

10. An organic chemical for creating diamond, comprising acetamide, urea, ethylene glycol, glycolic acid, lactamide, glycerol, hexamethylenetetramine, indene, 1,2-dimethylnaphtalene, 1,4- diisopropenylbenzene, cyclohexylphenylketone, 4'-cyclohexylacetophenone, 4-(1-adamantyl)phenol, 4,4'-methylenebis(2,6-dimethylphenol), α,α'-bis(4-hydroxyphenyl)-1,4-diisopropylbenzene, phenanthrene, lauric acid, sebacic acid and eicosanoic acid.
